(19) Europäisches Patentamt
European Patent Office
Office européen des brevets

(11) EP 2 284 629 A1

(12) **DEMANDE DE BREVET EUROPEEN**

(43) Date de publication:
**16.02.2011 Bulletin 2011/07**

(51) Int Cl.:
***G04B 17/06*** *(2006.01)*

(21) Numéro de dépôt: **09167805.2**

(22) Date de dépôt: **13.08.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(71) Demandeur: **ETA SA Manufacture Horlogère Suisse**
**2540 Grenchen (CH)**

(72) Inventeurs:
- **Cusin, Pierre**
**1423, Villars-Burquin (CH)**
- **Cabezas Jurin, Andrés**
**1400, Yverdon (CH)**

(74) Mandataire: **Couillard, Yann Luc Raymond et al**
**ICB**
**Ingénieurs Conseils en Brevets SA**
**Faubourg de l'Hôpital 3**
**2001 Neuchâtel (CH)**

(54) **Résonateur mécanique thermocompensé**

(57) L'invention se rapporte à un résonateur mécanique thermocompensé comportant une lame dont l'âme de section polygonale comporte du silicium monocristallin. Selon l'invention, l'âme comporte, sur une de ces faces ou sur plusieurs, un revêtement permettant de rendre ledit résonateur moins sensible aux variations de température.

L'invention concerne le domaine des pièces d'horlogerie.

l
b
h

Fig. 1

Fig. 2

EP 2 284 629 A1

## Description

### Domaine de l'invention

L'invention se rapporte à un résonateur mécanique thermocompensé et plus particulièrement à un tel résonateur comportant un ressort-spiral en silicium monocristallin thermocompensé.

### Arrière plan de l'invention

Le document EP 1 422 436 divulgue un ressort-spiral dont l'âme est en silicium monocristallin qui est recouvert par un revêtement de dioxyde de silicium afin de compenser thermiquement ledit ressort-spiral. Il permet ainsi de minimiser la variation du coefficient thermoélastique en fonction de la température. Cependant, le document se borne à divulguer un revêtement d'épaisseur égale ce qui peut rendre difficile son adaptation à un balancier pour obtenir un résonateur comportant un écart de marche minimal.

### Résumé de l'invention

Le but de la présente invention est de pallier tout ou partie les inconvénients cités précédemment en proposant un résonateur comportant plus de degrés de liberté quant à la formation de son revêtement autorisant la compensation thermique.

A cet effet, l'invention se rapporte à un résonateur mécanique thermocompensé comportant une lame dont l'âme de section polygonale comporte du silicium monocristallin **caractérisé en ce que** l'âme comporte, au moins sur une de ces faces, un revêtement permettant de rendre ledit résonateur moins sensible aux variations de température et, sur au moins une autre face, aucun revêtement ou **caractérisé en ce qu'**au moins deux faces adjacentes de l'âme ne sont pas revêtues de la même manière.

Conformément à d'autres caractéristiques avantageuses de l'invention :

- la section de la lame est un quadrilatère dont les faces sont identiques deux à deux ;
- le dépôt dudit revêtement est privilégié sur les faces parallèles par rapport au plan de flexion de la lame afin de modifier avec le plus d'intensité possible la fréquence dudit résonateur ou, inversement, avec les faces perpendiculaires pour modifier avec le moins d'intensité possible la fréquence dudit résonateur ;
- la lame est enroulée sur elle-même en formant au moins une spire et est couplée avec un volant d'inertie ;
- le revêtement comporte du dioxyde de silicium ;
- l'âme est réalisée à partir d'une plaque d'un plan de coupe {100} ou {111} de silicium monocristallin ;
- les épaisseurs de revêtement suivant le plan de coupe {100} ou {111} desdites faces deux à deux suivent sensiblement la relation :

$$Y = A \cdot X^3 + B \cdot X^2 + C \cdot X + D$$

Où:

- *Y* représente le pourcentage d'épaisseur du revêtement sur les faces parallèles à l'axe ($A_1$) de flexion de la lame par rapport à la hauteur (h) totale de la lame ;
- X représente le pourcentage d'épaisseur du revêtement sur les faces perpendiculaires à l'axe ($A_1$) de flexion de la lame par rapport à la base (b) totale de la lame ;
- A représente le coefficient du troisième degré du polynôme d'estimation de la courbe caractéristique qui s'élève à $-3{,}5302.10^{-5}$ ou $-3{,}5565.10^{-5}$ ;
- *B* représente le coefficient du deuxième degré du polynôme d'estimation de la courbe caractéristique qui s'élève à $-1{,}114.10^{-3}$ ou $-1{,}0642.10^{-3}$ ;
- C représente le coefficient du premier degré du polynôme d'estimation de la courbe caractéristique qui s'élève à -0,29152 ou
- 0,28721 ;
- D représente l'unité du polynôme d'estimation de la courbe caractéristique qui s'élève à 15,522 ou 16,446.

L'invention se rapporte à une pièce d'horlogerie comportant au moins un résonateur conforme à l'une des variantes précédemment citées.

### Description sommaire des dessins

D'autres particularités et avantages ressortiront clairement de la description qui en est faite ci-après, à titre indicatif et nullement limitatif, en référence aux dessins annexés, dans lesquels :

- la figure 1 est une représentation générale en perspective d'un ressort-spiral ;
- la figure 2 est une section représentative du ressort-spiral de la figure 1 ;
- la figure 3 est une représentation de plusieurs modes de réalisation selon l'invention ;
- la figure 4 est une représentation spatiale du module d'Young de la coupe {100} d'un silicium monocristallin en fonction de son orientation ;
- la figure 5 est une représentation de la variation du module d'Young de la coupe {100} d'un silicium monocristallin en fonction de sa température ;
- la figure 6 est une représentation spatiale du module d'Young de la coupe {111} d'un silicium monocristallin en fonction de son orientation ;

- la figure 7 est une représentation de la variation du module d'Young de la coupe {111} d'un silicium monocristallin en fonction de sa température ;
- la figure 8 est une représentation de la variation de fréquence du résonateur dont la lame est issue de la coupe {100} d'un silicium monocristallin en fonction de sa température et des épaisseurs de revêtement ;
- la figure 9 est une représentation verticale d'une partie de la figure 8 selon la direction de l'axe $b_1+b_3$ [%b] ;
- la figure 10 est une représentation verticale d'une partie de la figure 8 selon la direction de l'axe $h_1+h_3$ [%h] ;
- la figure 11 est une représentation horizontale d'une partie de la figure 8 selon la direction $\Delta F=1$ ;
- les figures 12 et 13 sont des représentations de la variation de fréquence du résonateur en fonction de la localisation et de l'épaisseur du revêtement ;
- la figure 14 est une représentation de la variation de fréquence du résonateur dont la lame est issue de la coupe {111} d'un silicium monocristallin en fonction de sa température et des épaisseurs de revêtement ;
- la figure 15 est une représentation verticale d'une partie de la figure 8 selon la direction de l'axe $b_1+b_3$ [%b] ;
- la figure 16 est une représentation verticale d'une partie de la figure 8 selon la direction de l'axe $h_1+h_3$ [%h] ;
- la figure 17 est une représentation horizontale d'une partie de la figure 8 selon la direction $\Delta F=1$.

Description détaillée des modes de réalisation préférés

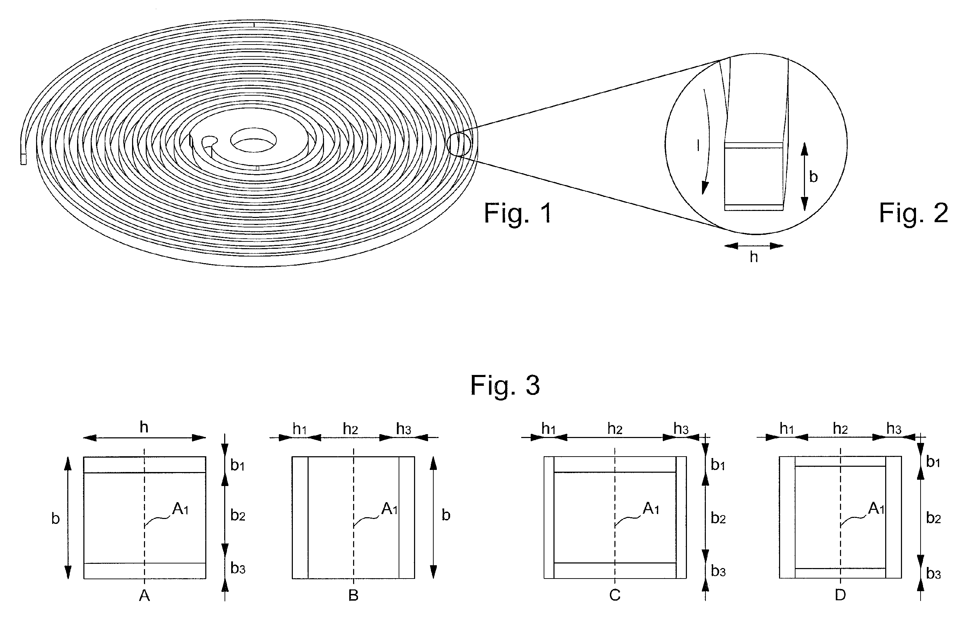

Comme illustré aux figures 1 et 2, on peut voir un ressort-spiral destiné à coopérer avec un balancier afin de former un résonateur mécanique. Le ressort-spiral est formé généralement par une lame enroulée en au moins une spire de longueur l et dont la section comporte une base b et une hauteur h.

Comme illustré à la figure 1, la lame est préférentiellement formée en une seule pièce avec sa virole. De manière préférée, cela est rendu possible par l'utilisation d'une plaquette de silicium monocristallin d'une épaisseur sensiblement correspondante à la grandeur de la base b, laquelle plaquette est gravée de part en part selon la forme du ressort-spiral et de sa virole à l'aide d'un gravage ionique réactif profond (également connu sous l'abréviation anglaise « DRIE »).

Comme illustré à la figure 2, on peut voir que la grandeur totale de la base b est formée par le silicium monocristallin mais également par deux revêtements opposés préférentiellement en dioxyde de silicium amorphe ($SiO_2$). Ce premier mode de réalisation est mieux représenté à la figure 3 au dessus de la référence A. A cette même figure 3, on remarque la ligne en traits interrompus nommée $A_1$ qui représente l'axe de flexion de la lame. Ainsi, dans le premier mode de réalisation A, seules les faces de la lame qui sont perpendiculaires à l'axe de flexion A1 sont recouvertes par un revêtement selon les épaisseurs respectives $b_1$ et $b_3$. On comprend donc que la grandeur totale b de la base est donc formée par ces revêtements $b_1$ et $b_3$, et de la grandeur $b_2$ de la partie en silicium monocristallin.

Dans le deuxième mode de réalisation B de la figure 3, seules les faces de la lame qui sont parallèles à l'axe de flexion A1 sont recouvertes par un revêtement selon les épaisseurs respectives $h_1$ et $h_3$. On comprend donc que la grandeur totale h de la hauteur est donc formée par ces revêtements $h_1$ et $h_3$, et de la grandeur $h_2$ de la partie en silicium monocristallin.

Dans le troisième mode de réalisation C de la figure 3, toutes les faces de la lame sont recouvertes par un revêtement. Les faces adjacentes de la lame ne sont pas revêtues de la même manière et, préférentiellement, sont identiques deux à deux. Ainsi, les faces qui sont parallèles à l'axe de flexion A1 sont recouvertes par un revêtement selon les épaisseurs respectives $h_1$ et $h_3$ et celles qui sont perpendiculaires à l'axe de flexion A1 sont recouvertes par un revêtement selon les épaisseurs respectives $b_1$ et $b_3$. On comprend donc que, d'une part, la grandeur totale h de la hauteur est donc formée par les revêtements $h_1$ et $h_3$, et de la grandeur $h_2$ de la partie en silicium monocristallin et, d'autre part, la grandeur totale b de la base est donc formée par les revêtements $b_1$ et $b_3$, et de la grandeur $b_2$ de la partie en silicium monocristallin. On remarque que les grandeurs $h_1$, $h_3$ sont plus petites que les grandeurs $b_1$, $b_3$.

Dans le quatrième mode de réalisation D de la figure 3, toutes les faces de la lame sont recouvertes par un revêtement de manière similaire au troisième mode de réalisation C. Les faces adjacentes de la lame ne sont pas revêtues de la même manière et, préférentiellement, sont identiques deux à deux. De manière opposée au troisième mode C de réalisation, les grandeurs $h_1$, $h_3$ sont plus grandes que les grandeurs $b_1$, $b_3$.

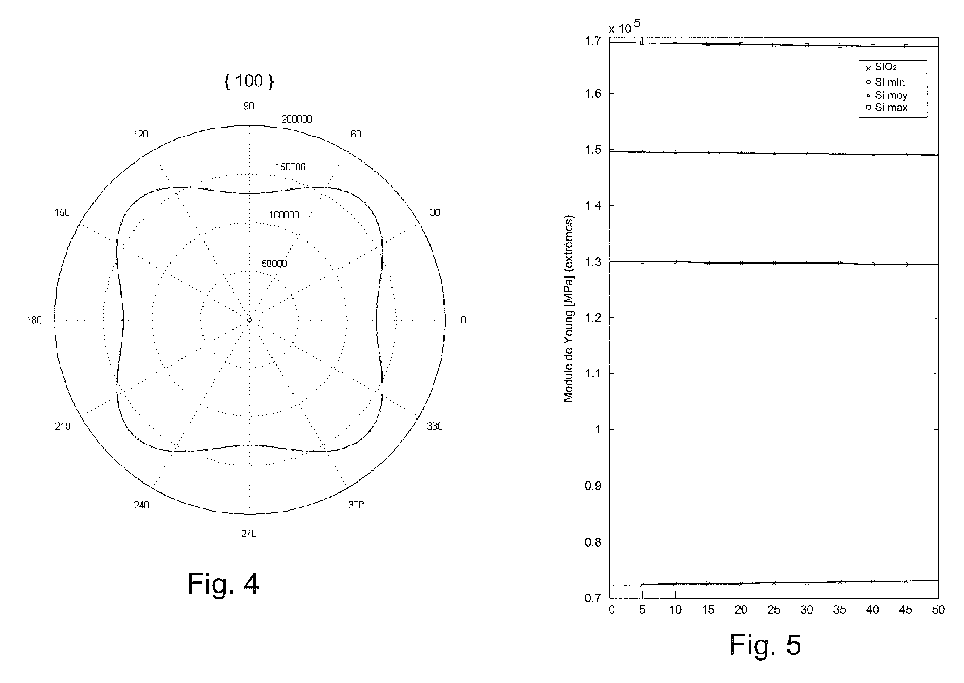

Selon l'invention, les quatre modes de réalisation A, B, C et D ont été étudiés à partir d'une lame formée dans une plaquette en silicium monocristallin coupée selon les plans {100} et {111}. Dans l'exemple illustré à la figure 4, on peut voir une représentation spatiale du module d'Young de la coupe {100} d'un silicium monocristallin en fonction de son orientation. On comprend ainsi que l'élasticité est variable suivant l'orientation de la flexion de la lame. Cependant, après calculs, on s'aperçoit que la construction de la lame en spirale se comporte en fait comme si elle avait un module d'Young moyen (△ $Si_{moy}$) comme illustré à la figure 5. A cette même figure, on peut voir que le coefficient thermo-élastique du silicium monocristallin est négatif (voir les repères □, ○, △) alors que celui du dioxyde de silicium amorphe ($SiO_2$) est positif (voir le repère x).

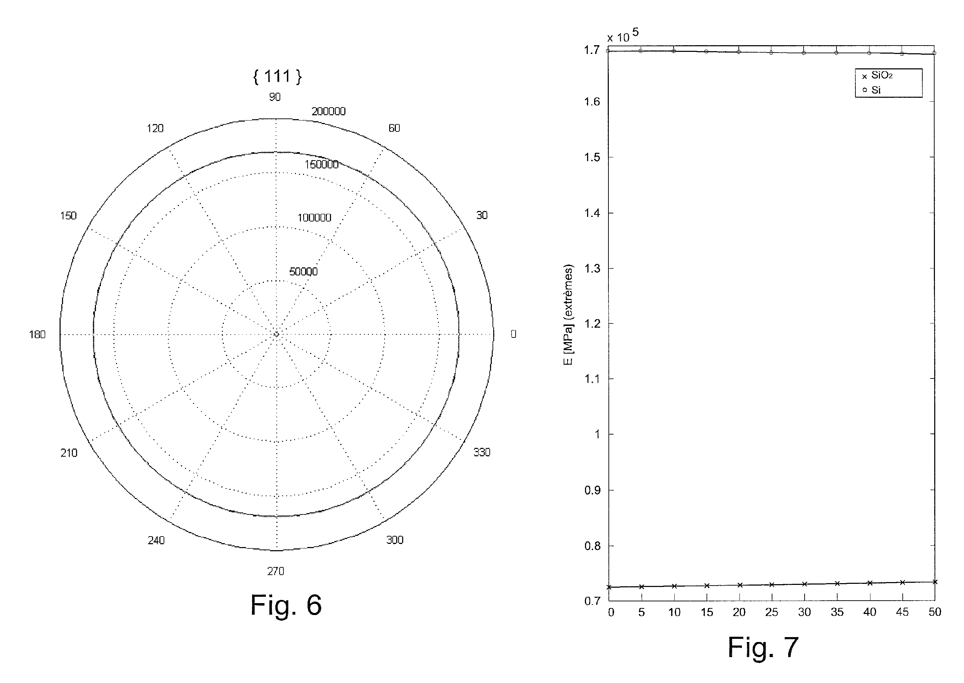

Ainsi, confronté aux figures 6 et 7, similaires respectivement aux figures 4 et 5 mais pour le plan de coupe {111}, on s'aperçoit qu'à part la valeur plus élevé du module d'Young, la lame formée à partir du plan {111} réagit de manière similaire à celle formée à partir du plan {100}, c'est-à-dire qu'elle peut être compensée par un revêtement de dioxyde de silicium amorphe ($SiO_2$).

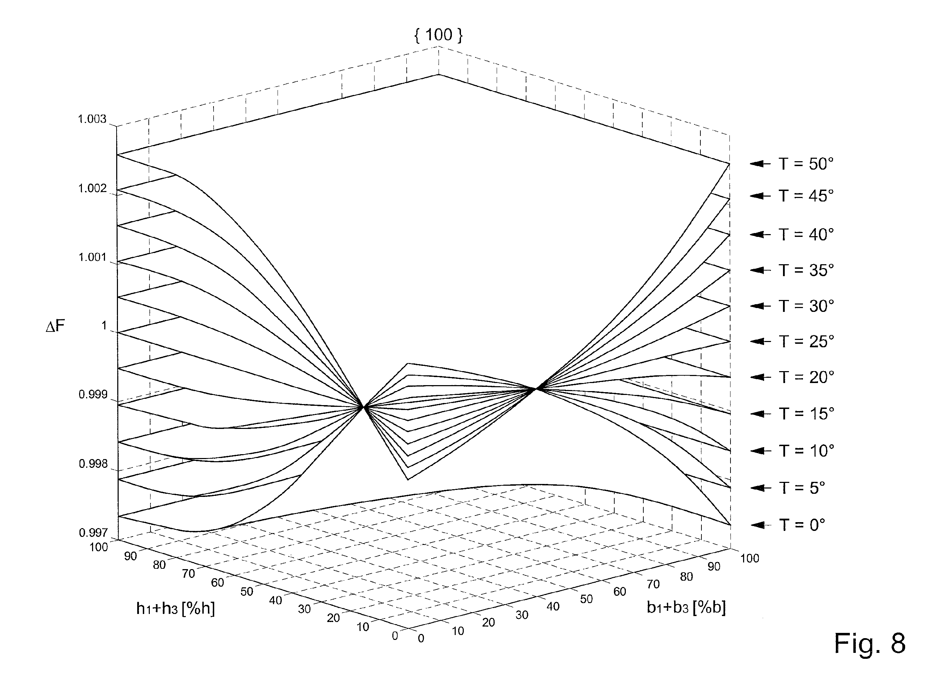

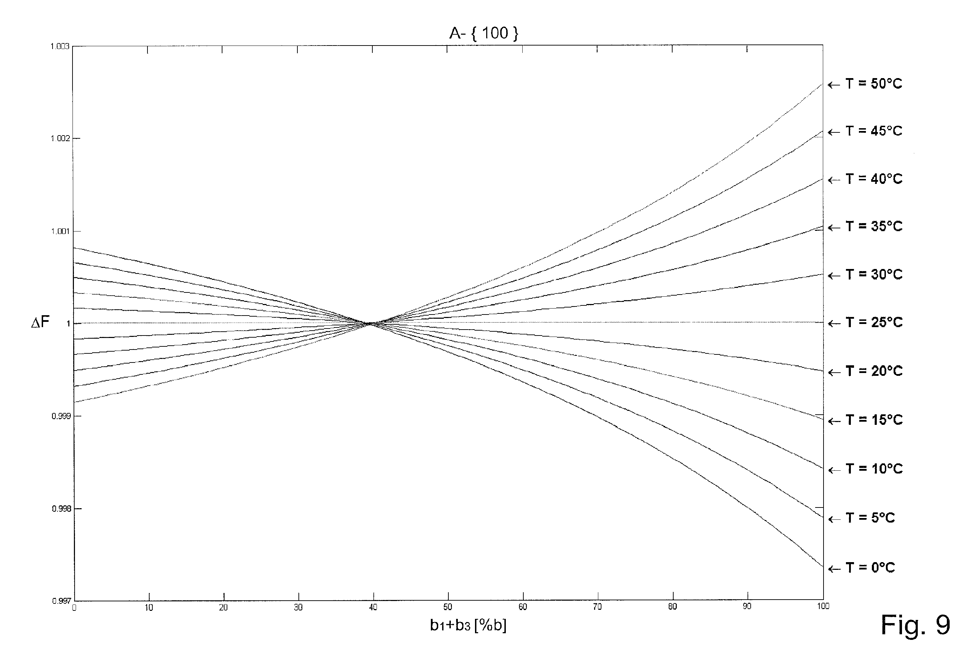

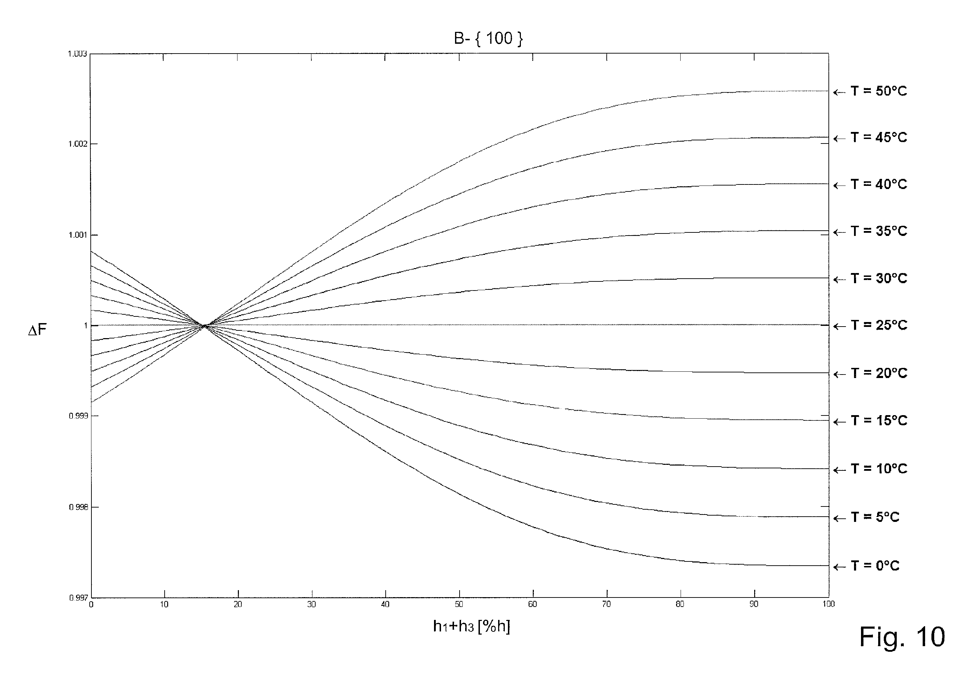

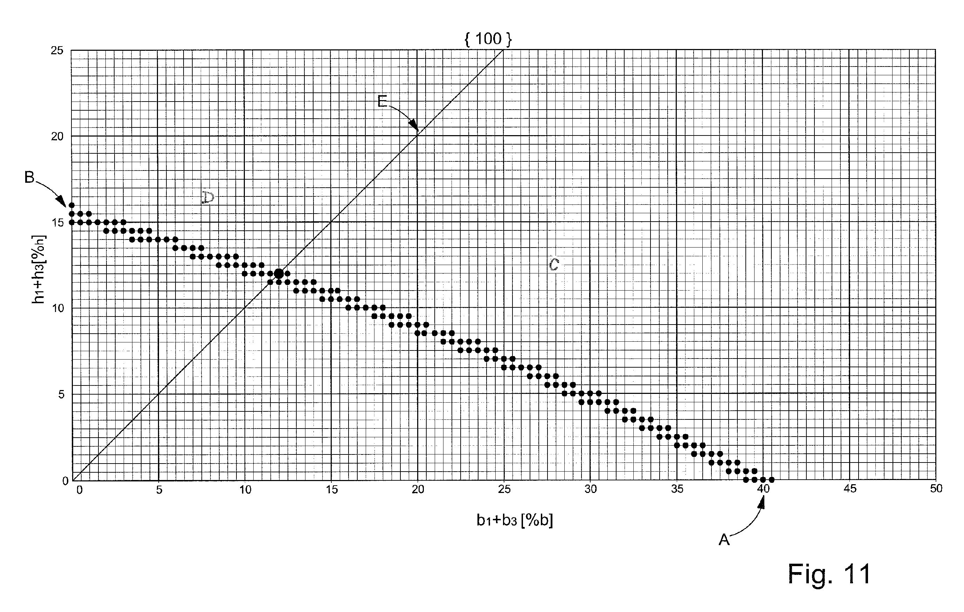

La figure 8 est une représentation complète des calculs effectués pour une lame formée dans une plaquette en silicium monocristallin coupée selon le plan {100}. La figure 8 présente la variation de fréquence du résonateur dont la lame est issue de la coupe {100} d'un silicium monocristallin en fonction de sa température et des épaisseurs de revêtement. On s'aperçoit qu'il y a une courbe de convergence entre les différents plans thermiques permettant d'obtenir un rapport $\Delta F$ sensiblement constant, c'est-à-dire égal à 1. Afin de mieux se rendre compte des courbes caractéristiques, un plan vertical d'une partie de la figure 8 selon la direction de l'axe $b_1+b_3$ [%b], c'est-à-dire %h=0 (figure 9), un autre selon la direction de l'axe $h_1+h_3$ [%h], c'est-à-dire %b=0 (figure 10) puis, enfin, un plan horizontal de la figure 8 selon la direction $\Delta F=1$ (figure 11).

Grâce à la figure 9, qui est en fait la courbe de thermocompensation du premier mode de réalisation A de la figure 3, on voit que les courbes thermiques convergent vers celle de 25°C au niveau du pourcentage $b_1+b_3$ par rapport à b sensiblement compris entre 39 et 41 %. Pour notre cas préféré dans lequel chaque face opposée respecte la relation $b_1 = b_3$, on a donc une épaisseur de revêtement pour le premier mode de réalisation A, pour chacune des deux faces, comprise entre 19,5 et 20,5%. Après un calcul plus fin, la valeur $b_1+b_3$ est estimée autour de 39,65%.

De manière similaire, à l'aide de la figure 10, qui est la courbe de thermocompensation du deuxième mode de réalisation B de la figure 3, on voit que les courbes thermiques convergent vers celle de 25°C au niveau du pourcentage $h_1+h_3$ par rapport à h sensiblement compris entre 15 et 16%. Pour notre cas préféré dans lequel chaque face opposée respecte la relation $h_1 = h_3$, on a donc une épaisseur de revêtement pour le premier mode de réalisation B, pour chacune des deux faces, comprise entre 7,5 et 8%. Après un calcul plus fin, la valeur $h_1+h_3$ est estimée autour de 15,49%.

La figure 11 permet de résumer la courbe à respecter pour compenser une lame formée d'une plaquette en silicium monocristallin coupée selon le plan {100} avec des revêtements en dioxyde de silicium amorphe ($SiO_2$). Ainsi, on retrouve les valeurs des premier et deuxième modes de réalisation A et B sur respectivement les abscisses et les ordonnées. De plus, on retrouve la courbe annotée E pour laquelle, le même pourcentage est appliqué sur toutes les faces de la lame, c'est-à-dire comme dans le document EP 1 422 436. Enfin, on peut voir que la courbe caractéristique entre le point B et la courbe E appartient au quatrième mode de réalisation D de la figure 3 et, entre la courbe E et le point A, au troisième mode de réalisation C de la figure 3.

Afin de simplifier la détermination des couches à former, un polynôme du troisième degré a été calculé afin de plus facilement mettre au point le résonateur :

$$Y = A \cdot X^3 + B \cdot X^2 + C \cdot X + D$$

Où :

- *Y* représente le pourcentage d'épaisseur du revêtement ($h_1+h_3$) sur les faces parallèles à l'axe ($A_1$) de flexion de la lame par rapport à la hauteur (h) totale de la lame ;
- X représente le pourcentage d'épaisseur du revêtement ($b_1+b_3$) sur les faces perpendiculaires à l'axe ($A_1$) de flexion de la lame par rapport à la base (b) totale de la lame ;
- A représente le coefficient du troisième degré du polynôme d'estimation de la courbe caractéristique qui s'élève à $-3{,}5302.10^{-5}$ ;
- B représente le coefficient du deuxième degré du polynôme d'estimation de la courbe caractéristique qui s'élève à $-1{,}114.10^{-3}$ ;
- C représente le coefficient du premier degré du polynôme d'estimation de la courbe caractéristique qui s'élève à -0,29152 ;
- D représente l'unité du polynôme d'estimation de la courbe caractéristique qui s'élève à 15,522.

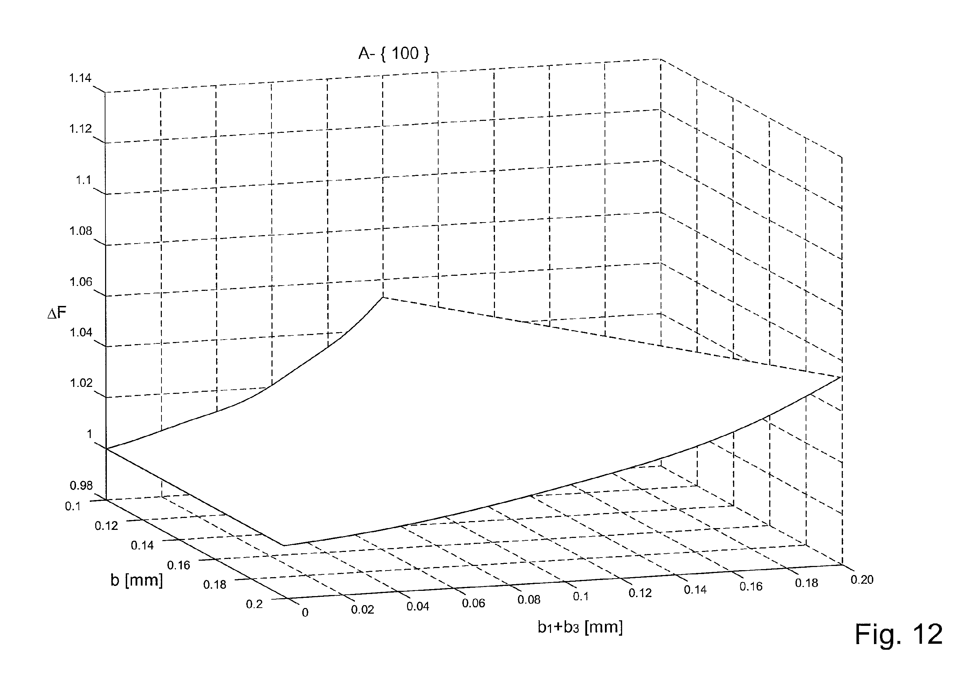

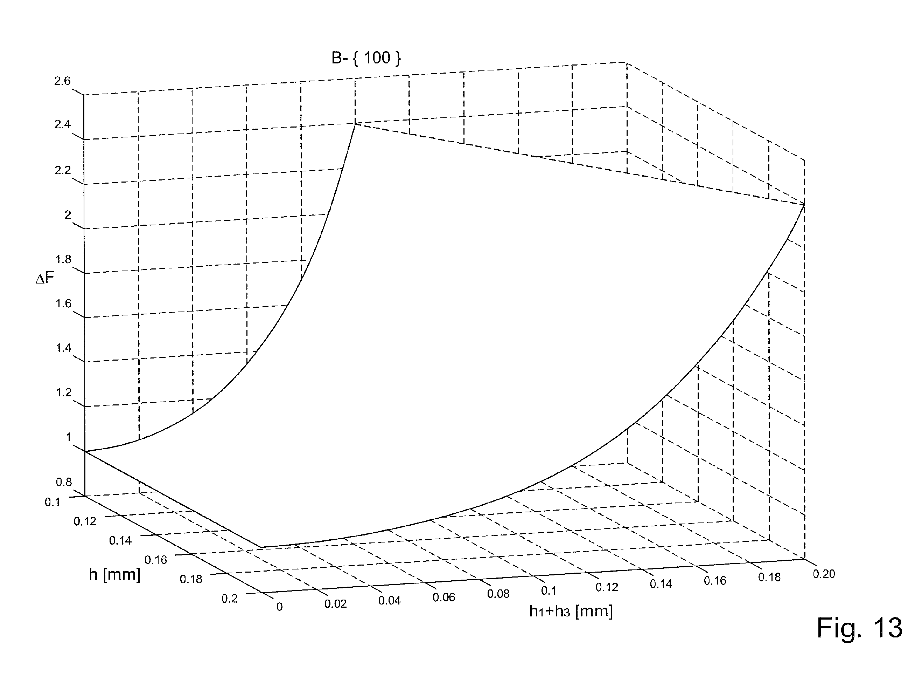

Enfin, les figures 12 et 13 montrent respectivement, de manière théorique, l'influence sur la fréquence du résonateur suivant que les revêtements recouvrent soit les faces perpendiculaires à l'axe de flexion A1 (mode de réalisation A) soit les faces parallèles à l'axe de flexion A1 (mode de réalisation B). On remarque que la fréquence sera beaucoup plus influencée quantitativement par un revêtement apporté sur les faces parallèles à l'axe de flexion A1 (mode de réalisation B) que par un revêtement apporté sur les faces perpendiculaires à l'axe de flexion A1 (mode de réalisation A). On en déduit donc que suivant l'adaptation à faire entre le spiral et le balancier pour former le résonateur, un des modes de réalisation A, B, C, D, E sera plus favorisé que les autres.

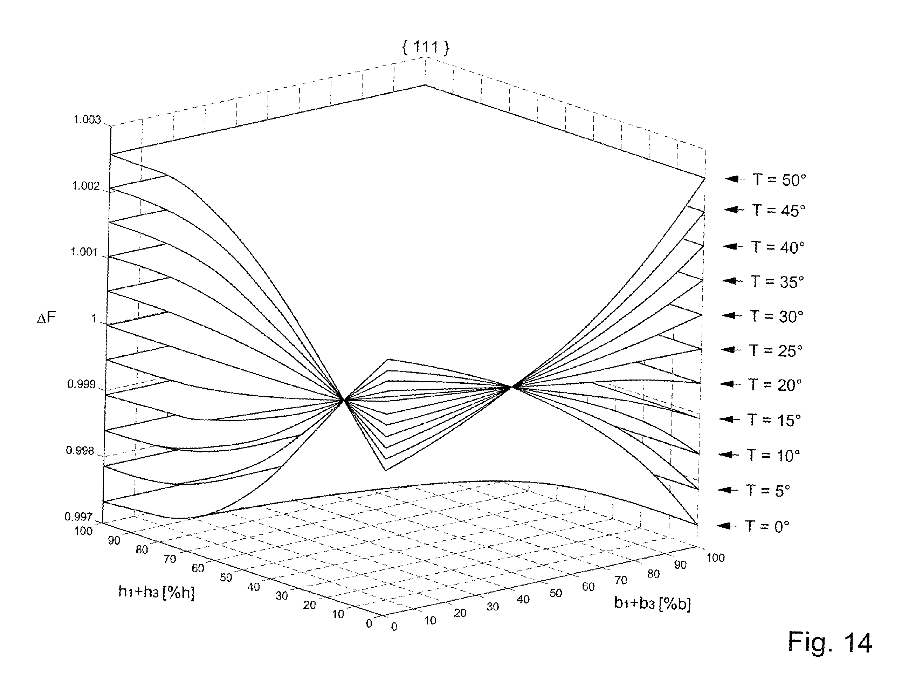

L'étude effectuée pour le plan de coupe {100} de la plaquette a également été effectuée pour le plan de coupe {111}. Ainsi, la figure 14 est une représentation complète des calculs effectués pour une lame formée dans une plaquette en silicium monocristallin coupée selon les plans {111}.

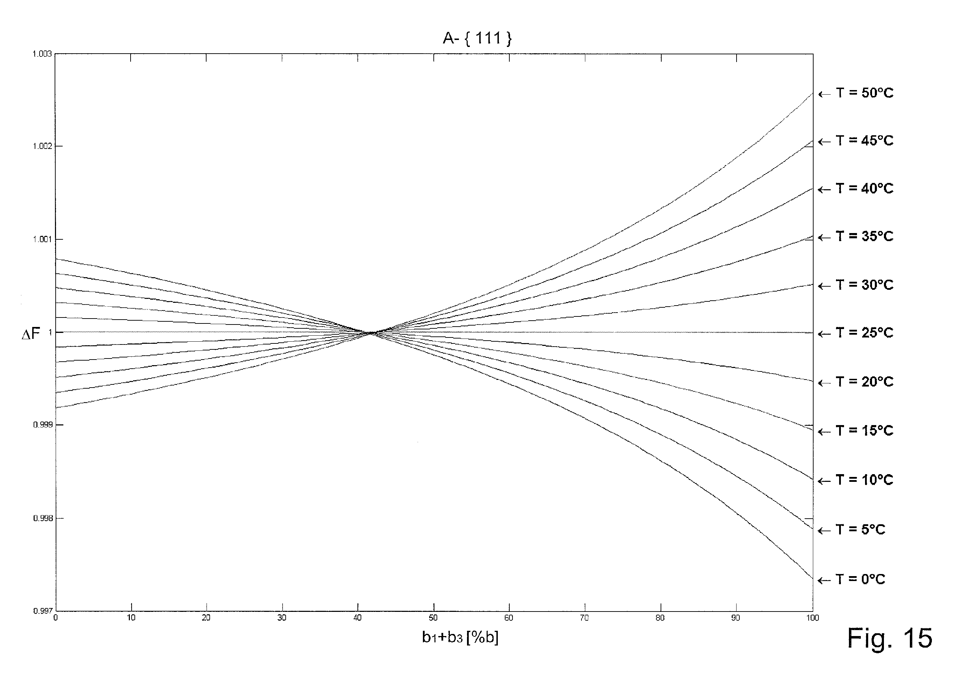

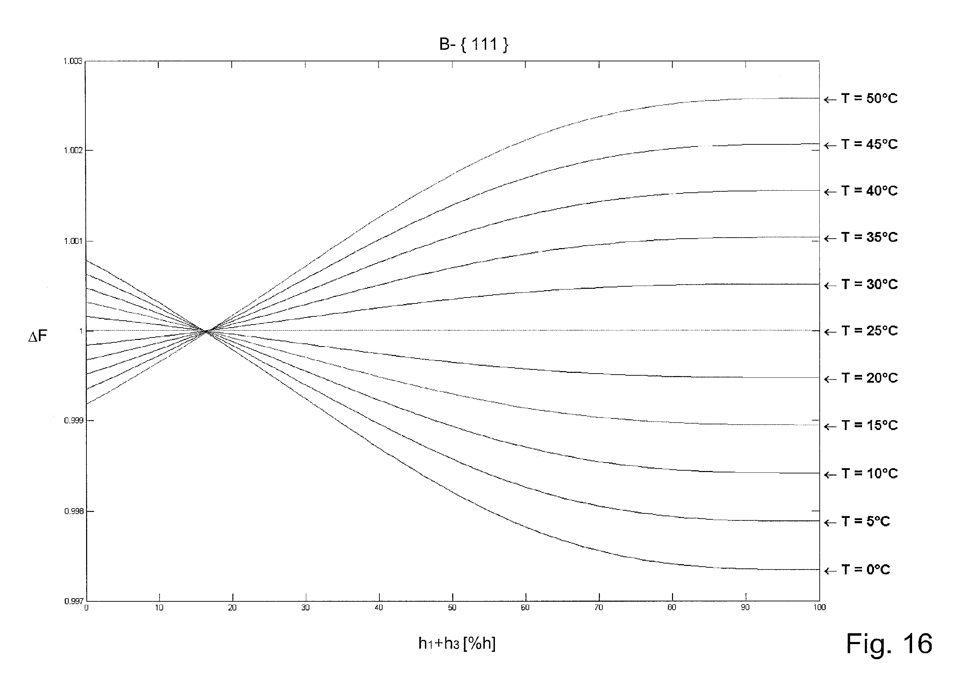

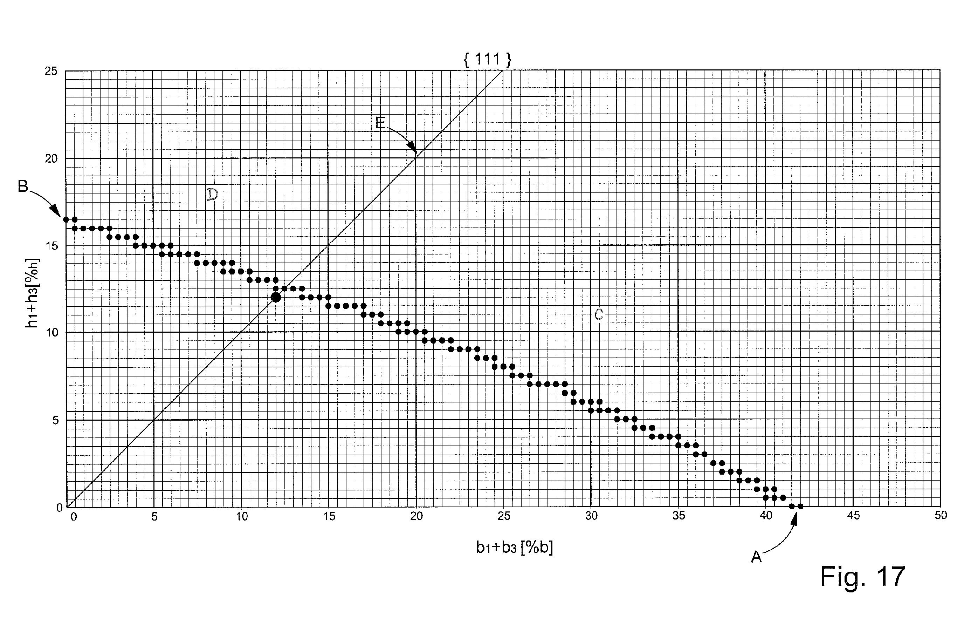

La figure 14 présente la variation de fréquence du résonateur dont la lame est issue de la coupe {111} d'un silicium monocristallin en fonction de sa température et des épaisseurs de revêtement. On s'aperçoit qu'il y a également une courbe de convergence entre les différents plans thermiques permettant d'obtenir de garder un rapport $\Delta F$ sensiblement constant, c'est-à-dire égal à 1. Afin de mieux se rendre compte des courbes caractéristiques, un plan vertical d'une partie de la figure 14 selon la direction de l'axe $b_1+b_3$ [%b], c'est-à-dire %h=0 (figure 15), un autre selon la direction de l'axe $h_1+h_3$ [%h], c'est-à-dire %b=0 (figure 16) puis, enfin, un plan horizontal de la figure 14 selon la direction $\Delta F=1$ (figure 17).

Grâce à la figure 15, qui est en fait la courbe de thermocompensation du premier mode de réalisation A de la figure 3, on voit que les courbes thermiques convergent vers celle de 25°C au niveau du pourcentage $b_1+b_3$ par rapport à b sensiblement compris entre 41 et 43%. Pour notre cas préféré dans lequel chaque face opposée respecte la relation $b_1 = b_3$, on a donc une épaisseur de revêtement pour le premier mode de réalisation A, pour chacune des deux faces, comprise entre 20,5 et 21,5%. Après un calcul plus fin, la valeur $b_1+b_3$ est estimée autour de 41,69%.

De manière similaire, à l'aide de la figure 16, qui est la courbe de thermocompensation du deuxième mode de réalisation B de la figure 3, on voit que les courbes thermiques convergent vers celle de 25°C au niveau du pourcentage $h_1+h_3$ par rapport à h sensiblement compris entre 16 et 17%. Pour notre cas préféré dans lequel chaque face opposée respecte la relation $h_1 = h_3$, on a donc une épaisseur de revêtement pour le premier mode de réalisation B, pour chacune des deux faces, comprise entre 8 et 8,5%. Après un calcul plus fin, la valeur $h_1+h_3$ est estimée autour de 16,46%.

La figure 17 permet de résumer la courbe à respecter pour compenser une lame formée d'une plaquette en silicium monocristallin coupée selon le plan {111} avec des revêtements en dioxyde de silicium amorphe ($SiO_2$). Ainsi, on retrouve les valeurs des premier et deuxième modes de réalisation A et B sur respectivement les abscisses et les ordonnées. De plus, on retrouve la courbe annotée E pour laquelle, le même pourcentage est appliqué sur toutes les faces de la lame, c'est-à-dire comme dans le document EP 1 422 436. Enfin, on peut voir que la courbe caractéristique entre le point B et la courbe E appartient au quatrième mode de réalisation D de la figure 3 et, entre la courbe E et le point A, au troisième mode de réalisation C de la figure 3.

Afin de simplifier la détermination des couches à former, un polynôme du troisième degré a été calculé afin de plus facilement mettre au point le résonateur :

$$Y = A \cdot X^3 + B \cdot X^2 + C \cdot X + D$$

Où :

- *Y* représente le pourcentage d'épaisseur du revêtement ($h_1+h_3$) sur les faces parallèles à l'axe ($A_1$) de flexion de la lame par rapport à la hauteur (h) totale de la lame ;
- X représente le pourcentage d'épaisseur du revêtement ($b_1+b_3$) sur les faces perpendiculaires à l'axe ($A_1$) de flexion de la lame par rapport à la base (b) totale de la lame ;
- *A* représente le coefficient du troisième degré du polynôme d'estimation de la courbe caractéristique qui s'élève à $-3{,}5565.10^{-5}$ ;
- *B* représente le coefficient du deuxième degré du polynôme d'estimation de la courbe caractéristique qui s'élève à $-1{,}0642.10^{-3}$ ;
- *C* représente le coefficient du premier degré du polynôme d'estimation de la courbe caractéristique qui s'élève à -0,28721 ;
- *D* représente l'unité du polynôme d'estimation de la courbe caractéristique qui s'élève à 16,446.

On en déduit donc que, comme pour le plan de coupe {100}, suivant l'adaptation à faire entre le spiral obtenue à partir d'un plan de coupe {111} d'un silicium monocristallin et le balancier (volant d'inertie) pour former le résonateur, un des modes de réalisation A, B, C, D, E sera plus favorisé que les autres. On note donc comme précédemment que le choix des plans de coupe {100} ou {111} n'a pas une influence déterminante.

**Revendications**

1. Résonateur mécanique thermocompensé comportant une lame dont l'âme de section polygonale comporte du silicium monocristallin **caractérisé en ce que** l'âme comporte, au moins sur une de ces faces, un revêtement permettant de rendre ledit résonateur moins sensible aux variations de température et, sur au moins une autre face, aucun revêtement.

2. Résonateur thermocompensé comportant une lame dont l'âme polygonale comporte du silicium monocristallin et est recouverte par un revêtement permettant de rendre ledit résonateur moins sensible aux variations de température **caractérisé en ce qu'**au moins deux faces adjacentes de l'âme ne sont pas revêtues de la même manière.

3. Résonateur selon la revendication 1 ou 2, **caractérisé en ce que** la section de la lame est un quadrilatère dont les faces sont identiques deux à deux.

4. Résonateur selon l'une des revendications précédentes, **caractérisé en ce que** le dépôt dudit revêtement est privilégié sur les faces parallèles par rapport au plan de flexion de la lame afin de modifier avec le plus d'intensité possible la fréquence dudit résonateur.

5. Résonateur selon l'une des revendications précédentes, **caractérisé en ce que** la lame est enroulée sur elle-même en formant au moins une spire et est couplée avec un volant d'inertie.

6. Résonateur selon l'une des revendications précédentes, **caractérisé en ce que** le revêtement comporte du dioxyde de silicium.

**7.** Résonateur selon l'une des revendications précédentes, **caractérisé en ce que** l'âme est réalisée à partir d'une plaque d'un plan de coupe {100} de silicium monocristallin.

**8.** Résonateur selon la revendication 7, **caractérisé en ce que** les épaisseurs de revêtement desdites faces deux à deux suivent sensiblement la relation :

$$Y = A \cdot X^3 + B \cdot X^2 + C \cdot X + D$$

Où :

- *Y* représente le pourcentage d'épaisseur du revêtement sur les faces parallèles à l'axe ($A_1$) de flexion de la lame par rapport à la hauteur (h) totale de la lame ;
- *X* représente le pourcentage d'épaisseur du revêtement sur les faces perpendiculaires à l'axe ($A_1$) de flexion de la lame par rapport à la base (b) totale de la lame ;
- *A* représente le coefficient du troisième degré du polynôme d'estimation de la courbe caractéristique qui s'élève à $-3,5302.10^{-5}$ ;
- *B* représente le coefficient du deuxième degré du polynôme d'estimation de la courbe caractéristique qui s'élève à $-1,114.10^{-3}$ ;
- *C* représente le coefficient du premier degré du polynôme d'estimation de la courbe caractéristique qui s'élève à -0,29152 ;
- *D* représente l'unité du polynôme d'estimation de la courbe caractéristique qui s'élève à 15,522.

**9.** Résonateur selon l'une des revendications 1 à 6, **caractérisé en ce que** l'âme est réalisée à partir d'une plaque d'un plan de coupe {111} de silicium monocristallin.

**10.** Résonateur selon la revendication 9, **caractérisé en ce que** les épaisseurs de revêtement desdites faces deux à deux suivent sensiblement la relation :

$$Y = A \cdot X^3 + B \cdot X^2 + C \cdot X + D$$

Où :

- *Y* représente le pourcentage d'épaisseur du revêtement sur les faces parallèles à l'axe ($A_1$) de flexion de la lame par rapport à la hauteur (h) totale de la lame ;
- *X* représente le pourcentage d'épaisseur du revêtement sur les faces perpendiculaires à l'axe ($A_1$) de flexion de la lame par rapport à la base (b) totale de la lame ;
- *A* représente le coefficient du troisième degré du polynôme d'estimation de la courbe caractéristique qui s'élève à $-3,5565.10^{-5}$ ;
- *B* représente le coefficient du deuxième degré du polynôme d'estimation de la courbe caractéristique qui s'élève à $-1,0642.10^{-3}$ ;
- *C* représente le coefficient du premier degré du polynôme d'estimation de la courbe caractéristique qui s'élève à -0,28721 ;
- *D* représente l'unité du polynôme d'estimation de la courbe caractéristique qui s'élève à 16,446.

**11.** Pièce d'horlogerie **caractérisée en ce qu'**elle comporte au moins un résonateur mécanique conforme à l'une des revendications précédentes.

Fig. 1
Fig. 2
Fig. 3
h
b
l
A
B
C
D
A1
h1
h2
h3
b1
b2
b3

x 10^5
1.7
1.6
1.5
1.4
1.3
1.2
1.1
1
0.9
0.8
0.7
Module de Young [MPa] (extrêmes)
0
5
10
15
20
25
30
35
40
45
50
× SiO₂
○ Si min
▵ Si moy
□ Si max

Fig. 5

{ 100 }
0
30
60
90
120
150
180
210
240
270
300
330
50000
100000
150000
200000

Fig. 4

x 10^5
E [MPa] (extrêmes)
× SiO2
○ Si
1.7
1.6
1.5
1.4
1.3
1.2
1.1
1
0.9
0.8
0.7
0
5
10
15
20
25
30
35
40
45
50

Fig. 7

{ 111 }
90
60
30
0
330
300
270
240
210
180
150
120
50000
100000
150000
200000

Fig. 6

{ 100 }
T = 50°
T = 45°
T = 40°
T = 35°
T = 30°
T = 25°
T = 20°
T = 15°
T = 10°
T = 5°
T = 0°
ΔF
1.003
1.002
1.001
1
0.999
0.998
0.997
h1+h3 [%h]
b1+b3 [%b]
100
90
80
70
60
50
40
30
20
10
0

Fig. 8

A- { 100 }
ΔF
b1+b3 [%b]
1.003
1.002
1.001
1
0.999
0.998
0.997
0
10
20
30
40
50
60
70
80
90
100
← T = 50°C
← T = 45°C
← T = 40°C
← T = 35°C
← T = 30°C
← T = 25°C
← T = 20°C
← T = 15°C
← T = 10°C
← T = 5°C
← T = 0°C

Fig. 9

B- { 100 }
ΔF
h1+h3 [%h]
← T = 50°C
← T = 45°C
← T = 40°C
← T = 35°C
← T = 30°C
← T = 25°C
← T = 20°C
← T = 15°C
← T = 10°C
← T = 5°C
← T = 0°C
1.003
1.002
1.001
1
0.999
0.998
0.997
0
10
20
30
40
50
60
70
80
90
100

Fig. 10

{ 100 }
E
D
C
A
B
b1+b3 [%b]
h1+h3[%h]

Fig. 11

A- { 100 }
ΔF
1.14
1.12
1.1
1.08
1.06
1.04
1.02
1
0.98
b [mm]
0.1
0.12
0.14
0.16
0.18
0.2
b1+b3 [mm]
0
0.02
0.04
0.06
0.08
0.1
0.12
0.14
0.16
0.18
0.20

Fig. 12

B- { 100 }
ΔF
2.6
2.4
2.2
2
1.8
1.6
1.4
1.2
1
0.8
h [mm]
0.1
0.12
0.14
0.16
0.18
0.2
h1+h3 [mm]
0
0.02
0.04
0.06
0.08
0.1
0.12
0.14
0.16
0.18
0.20

Fig. 13

{ 111 }
T = 50°
T = 45°
T = 40°
T = 35°
T = 30°
T = 25°
T = 20°
T = 15°
T = 10°
T = 5°
T = 0°
ΔF
1.003
1.002
1.001
1
0.999
0.998
0.997
$h_1+h_3$ [%h]
$b_1+b_3$ [%b]
100
90
80
70
60
50
40
30
20
10
0

Fig. 14

A- { 111 }
ΔF
1.003
1.002
1.001
1
0.999
0.998
0.997
0
10
20
30
40
50
60
70
80
90
100
$b_1+b_3$ [%b]
← T = 50°C
← T = 45°C
← T = 40°C
← T = 35°C
← T = 30°C
← T = 25°C
← T = 20°C
← T = 15°C
← T = 10°C
← T = 5°C
← T = 0°C

Fig. 15

B- { 111 }
ΔF
h1+h3 [%h]
T = 50°C
T = 45°C
T = 40°C
T = 35°C
T = 30°C
T = 25°C
T = 20°C
T = 15°C
T = 10°C
T = 5°C
T = 0°C
1.003
1.002
1.001
1
0.999
0.998
0.997
0
10
20
30
40
50
60
70
80
90
100

Fig. 16

{ 111 }
E
C
D
A
B
$b_1+b_3$ [%b]
$h_1+h_3$[%h]
0
5
10
15
20
25
30
35
40
45
50

Fig. 17

Europäisches Patentamt
European Patent Office
Office européen des brevets

# RAPPORT DE RECHERCHE EUROPEENNE

Numéro de la demande
EP 09 16 7805

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| D,X | EP 1 422 436 A (CSEMCT SUISSE D ELECTRONIQUE E [CH] SUISSE ELECTRONIQUE MICROTECH [CH]) 26 mai 2004 (2004-05-26) | 2 | INV. G04B17/06 |
| A | * alinéas [0001] - [0040] * * figures 1-3 * | 1,3-11 | |
| X | WO 2009/068091 A (MANUF ET FABRIQUE DE MONTRES E [CH]; GYGAX PIERRE [CH]; GLASSEY MARC-A) 4 juin 2009 (2009-06-04) | 2,6 | |
| A | * page 2, ligne 8 - page 9, ligne 11 * * figures 1-4 * | 1,3-5, 7-11 | |
| A | EP 0 732 635 A (SUISSE ELECTRONIQUE MICROTECH [CH]) 18 septembre 1996 (1996-09-18) * colonne 2, ligne 1-26 * * colonne 2, ligne 48 - colonne 3, ligne 18 * * colonne 4, ligne 10 * | 1-11 | |
| A | EP 1 791 039 A (SWATCH GROUP RES & DEV LTD [CH]) 30 mai 2007 (2007-05-30) * le document en entier * | 1,2 | DOMAINES TECHNIQUES RECHERCHES (IPC) G04B |

Le présent rapport a été établi pour toutes les revendications

| Lieu de la recherche | Date d'achèvement de la recherche | Examinateur |
|---|---|---|
| La Haye | 15 janvier 2010 | Burns, Mike |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

3
EPO FORM 1503 03.82 (P04C02)

**ANNEXE AU RAPPORT DE RECHERCHE EUROPEENNE RELATIF A LA DEMANDE DE BREVET EUROPEEN NO.** EP 09 16 7805

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-01-2010

| Document brevet cité au rapport de recherche | Date de publication | Membre(s) de la famille de brevet(s) | Date de publication |
|---|---|---|---|
| EP 1422436 A | 26-05-2004 | AT 307990 T | 15-11-2005 |
| | | AU 2003271504 A1 | 18-06-2004 |
| | | WO 2004048800 A1 | 10-06-2004 |
| | | CN 1717552 A | 04-01-2006 |
| | | DE 60206939 D1 | 01-12-2005 |
| | | DE 60206939 T2 | 27-07-2006 |
| | | HK 1067687 A1 | 19-05-2006 |
| | | JP 2006507454 T | 02-03-2006 |
| | | US 2005281137 A1 | 22-12-2005 |
| WO 2009068091 A | 04-06-2009 | AUCUN | |
| EP 0732635 A | 18-09-1996 | DE 69608724 D1 | 13-07-2000 |
| | | DE 69608724 T2 | 08-02-2001 |
| | | FR 2731715 A1 | 20-09-1996 |
| EP 1791039 A | 30-05-2007 | CN 101361027 A | 04-02-2009 |
| | | EP 1958031 A2 | 20-08-2008 |
| | | WO 2007059876 A2 | 31-05-2007 |
| | | JP 2009517637 T | 30-04-2009 |
| | | KR 20080072002 A | 05-08-2008 |
| | | US 2009016173 A1 | 15-01-2009 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 1422436 A